# EUROPÄISCHE PATENTSCHRIFT

(11) **EP 0 623 950 B1**
(45) Veröffentlichungstag und Bekanntmachung des Hinweises auf die Patenterteilung: **18.06.1997**
(21) Anmeldenummer: 94106815.7
(22) Anmeldetag: 02.05.1994
(51) Int. Cl.: C23C 14/48, H01L 21/265, H01L 21/74, H01L 23/48, G02B 6/10

(54) **Verfahren zur Herstellung röhrenförmiger Mikrostrukturen in Festkörpern**
Process for manufacturing tubular microstructures in solid state bodies
Procédé de fabrication de structures tubulaires dans des corps à l'état solide

(30) Priorität: 03.05.1993 DE 4315329
(43) Veröffentlichungstag der Anmeldung: 09.11.1994
(73) Patentinhaber: Forschungszentrum Rossendorf e.V., D-01474 Rossendorf (DE)
(72) Erfinder: Heinig, Karl-Heinz, Dr., D-01237 Dresden (DE); Reiss, Stefan, D-01474 Rossendorf (DE); Schmidt, Bernd, Dr., D-01187 Dresden (DE); Skorupa, Wolfgang, Dr., D-01478 Weixdorf (DE)

(56) Entgegenhaltungen:
- EP-A- 0 259 282
- EP-A- 0 298 794
- ION BEAM SYNTHESIS OF COMPOUND AND ELEMENTAL LAYERS. SYMPOSIUM D OF THE 1991 E-MRS SPRING MEETING, STRASBOURG, FRANCE, 28-31 MAY 1991, ISSN 0921-5107, MATERIALS SCIENCE & ENGINEERING B (SOLID-STATE MATERIALS FOR ADVANCED TECHNOLOGY), 20 JAN. 1992, SWITZERLAND, PAGE(S) 41 - 45, XP360320 Robinson A K et al 'Low energy, oxygen dose optimization for thin film separation by implanted oxygen'
- APPLIED PHYSICS LETTERS, 22 JUNE 1992, USA, VOL. 60, NR. 25, PAGE(S) 3147 - 3149, ISSN 0003-6951, XP280710 Venables D et al 'Low-dislocation-density silicon-on-insulator material produced by sequential oxygen implantation and low-temperature annealing'
- APPLIED PHYSICS LETTERS, 16 DEC. 1991, USA, VOL. 59, NR. 25, PAGE(S) 3249 - 3251, ISSN 0003-6951, XP257916 George T et al 'Endotaxial growth of CoSi/sub 2/ within (111) oriented Si in a molecular beam epitaxy system'
- APPLIED PHYSICS LETTERS, 25 JAN. 1993, USA, VOL. 62, NR. 4, PAGE(S) 387 - 389, ISSN 0003-6951 Zimmerman N M et al 'Transport in submicrometer buried mesotaxial cobalt silicide wires'
- BEAM SOLID INTERACTIONS: FUNDAMENTALS AND APPLICATIONS SYMPOSIUM, BOSTON, MA, USA, 30 NOV.-4 DEC. 1992, 1993, PITTSBURGH, PA, USA, MATER. RES. SOC, USA, PAGE(S) 881 - 886 Liddle J A et al 'Sub-micron mesotaxial CoSi/sub 2/ wires'
- IBM TECHNICAL DISCLOSURE BULLETIN, Bd.32, Nr.3B, August 1989, NEW YORK, US Seiten 403 - 407 ANONYMOUS 'Single-Crystal Silicon Embedded With Insulated Conducting Wires'
- SYMPOSIUM G: MATERIAL ASPECTS OF ION BEAM SYNTHESIS: PHASE FORMATION AND MODIFICATION, OF THE E-MRS SPRING MEETING, STRASBOURG, FRANCE, 4-7 MAY 1993, ISSN 0168-583X, NUCLEAR INSTRUMENTS & METHODS IN PHYSICS RESEARCH, SECTION B (BEAM INTERACTIONS WITH MATERIALS AND ATOMS), FEB. 1994, NETHERLANDS, PAGE(S) 229 - 233 Reiss S et al 'Ostwald ripening during ion beam synthesis-a computer simulation for inhomogeneous systems'

## Beschreibung

Die Erfindung bezieht sich auf ein Verfahren zur Herstellung röhrenförmiger Mikrostrukturen unter einer Festkörperoberfläche, die aus einer chemischen Verbindung der Festkörperatome mit Fremdatomen besteht.

Verfahren zur Herstellung unter der Festkörperoberfläche vergrabener Strukturen aus einer chemischen Verbindung der Festkörperatome mit Fremdatomen werden vor allem bei der Herstellung von Halbleitervorrichtungen auf der Basis von monokristallinem Silicium angewendet, wobei unter die Oberfläche eines einkristallinen, insbesondere scheibenförmigen Siliciumkörpers überwiegend Sauerstoffatome eingeschossen werden, die in einer Tiefe von maximal einigen Mikrometern zur Ruhe kommen und mit dem Siliciumkörper Siliciumdioxid bilden, das zu einer glatten vergrabenen Siliciumdioxidschicht gesintert wird [ US-A-3855009 ]. Diese Siliciumdioxidschicht isoliert elektrisch eine dünne einkristalline Siliciumoberflächenschicht vom Siliciumkörper. Diese vom Siliciumkörper dielektrisch isolierte Siliciumoberflächenschicht ist hervorragendes Grundmaterial für die Herstellung von Halbleiterbauelementen und von Vorrichtungen für die Mikromechanik und die Sensorik. In der Halbleiterindustrie ist die Herstellung solcher dünnen, dielektrisch isolierten Siliciumschichten als SIMOX--Technologie bekannt. Dielektrisch isolierte Siliciumschichten können auch durch Ionenimplantation anderer Elemente, z.B. Stickstoff, erzeugt werden.

Es wird auch ein Verfahren zur Herstellung unter der Festkörperoberfläche vergrabener Strukturen aus einer chemischen Verbindung der Festkörperatome mit Fremdatomen für die Herstellung von Halbleitervorrichtungen auf der Basis von monokristallinem Silicium genutzt, bei dem unter die Oberfläche eines einkristallinen, insbesondere scheibenförmigen Siliciumkörpers Metallatome, z.B. Kobalt, eingeschossen werden, die in einer Tiefe von weniger als einem Mikrometer zur Ruhe kommen und durch eine Temperbehandlung mit dem Siliciumkörper Silicide bilden, die zu einer glatten vergrabenen Silicidschicht gesintert werden [ US-A-4816421 ]. Durch photolithografische Verfahren lassen sich die Schichten in Streifen mit einer Breite von weniger als einem Mikrometer herstellen und als vergrabene Leitbahnen einsetzen [N.M. Zimmermann, J.A. Liddle, A.E. White und K.T. Short, , Appl. Phys. Lett. 62(1993)387 ; J.A. Liddle, N.M. Zimmermann, A.E. White, K.T. Short, L.. Fetter, Mat. Res. Soc. Symp. Proc. 279(1993)882 ].

Wünschenswert für neuartige Anwendung sind röhrenförmige vergrabene Mikrostrukturen unter der Halbleiteroberfläche, wie z.B. dielektrisch isolierte leitende Bahnen oder elektrisch abgeschirmte (koaxiale) Drähte von weniger als einem Mikrometer Durchmesser. Mit Hilfe von dielektrisch isolierten Leitbahnen lassen sich z.B. parasitäre Ströme verringern. Dielektrisch isolierte vergrabene Drähte können auch über den elektrischen Feldeffekt Ströme in Halbleitervorrichtungen steuern. Röhrenförmige Strukturen sind weiterhin für optische, optoelektronische, sensorische und mikromechanische Anwendungen vorteilhaft.

Es ist daher Aufgabe der Erfindung, ein Verfahren zu schaffen, das die Herstellung von röhrenförmigen Strukturen unter der Oberfläche von Festkörpern, insbesondere unter der Oberfläche monokristalliner scheibenförmiger Siliciumkörper, ermöglicht, die für die obengenannten neuartigen Anwendungen geeignet sind.

Dieses in den Patentansprüchen dargelegte Verfahren besteht erfindungsgemäß darin, daß in ein in Höhe und Breite auf Submikrometerabmessungen begrenztes Gebiet (G) eines Festkörpers (F) Fremdatome (FA) eingebracht werden, die mit den Festkörperatomen eine chemische Verbindung einzugehen geeignet sind, wobei die Konzentration der Fremdatome im Gebiet (G) nach dem Einbringen maximal 50% der der Stöchiometrie entsprechende Konzentration der Fremdatome in der chemischen Verbindung beträgt, und daß anschließend eine Temperbehandlung bei hohen Temperaturen unterhalb der Schmelztemperaturen des Festkörpermaterials und der chemischen Verbindung derart erfolgt, daß sich Festkörpermaterial und chemische Verbindung durch Bildung von Präzipitaten der chemischen Verbindung entmischen, daß die Präzipitate über das an sich bekannte Ostwaldreifen weiter wachsen und sich in einer oder mehreren Zylinderschalen konzentrieren, bis über die Koaleszenz der Präzipitate scharfe Phasengrenzen zwischen der in den Zylinderschalen konzentrierten chemischen Verbindung und dem Festkörpermaterial innerhalb und außerhalb dieser Schalen entstanden sind.

Dieses erfindungsgemäße Verfahren basiert auf der neu gewonnenen Erkenntnis, daß Fremdatome in geeigneter Konzentration in ein zylinderförmiges Gebiet von wenigen Zehntel Mikrometer Durchmesser unter die Festkörperoberfläche so eingebracht werden können, daß sich aufgrund der Ostwaldreifung die aus der chemischen Verbindung zwischen den Fremdatomen und dem Festkörpermatrial bildenden Präzipitate beim nachfolgenden Tempern zu Zylinderschalen selbst organisieren.

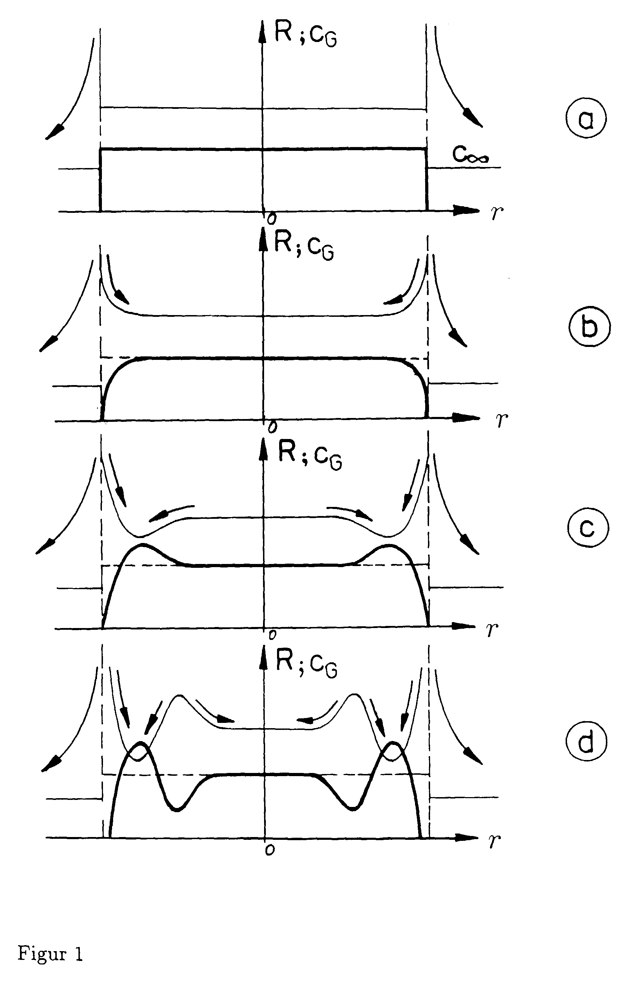

In Abb. 1 ist der durch das Tempern ausgelöste Prozeß der Selbstorganisation der Präzipitate dargestellt. Durch Einbringen der Fremdatome bilden sich über den gesamten Querschnitt des zylinderförmigen Gebietes sofort (z.B. bei Ionenimplantation deutlich oberhalb der Zimmertemperatur) oder zu Beginn des Temperschrittes Präzipitate aus, die über den Querschnitt etwa den gleichen mittleren Radius haben (Abb. 1a, dicke Kurve). Jedes Präzipitat weist eine von seinem Radius abhängige Gleichgewichtslöslichkeit der Fremdatome im Festkörpermaterial auf (je kleiner das Präzipitat, desto größer ist seine Gleichgewichtslöslichkeit). Für die Präzipitatverteilung des Anfangszustandes (Abb.1a, dicke Kurve) findet man somit über den Querschnitt des zylinderförmigen Gebietes eine etwa konstante Konzentration der im Festkörpermaterial gelösten Fremdatome (Abb 1a, dünne Kurve). Außerhalb des zylinderförmigen Gebietes ist die Gleichgewichtskonzentration der Fremdatome im Festkörpermaterial die Soliduskonzentration, d.h. die Gleichgewichtskonzentration der Fremdatome im Festkörpermaterial an einer ebenen Grenzfläche zwischen der chemischen Verbindung und dem Festkörpermaterial (Abb. 1a, dünne Kurve).

Beim Tempern ist die Diffusion bestrebt, die Konzentrationsunterschiede außerhalb und innerhalb des zylinderförmigen Gebietes auszugleichen. Die Präzipitate am Rande des zylinderförmigen Gebietes sind deshalb gezwungen, sich teilweise aufzulösen und dadurch im Festkörpermaterial gelöste Fremdatome nachzuliefern, damit ihre Gleichgewichtskonzentration an ihrer Oberfläche erhalten bleibt. Das führt zu einer Verringerung des mittleren Radius der Präzipitate am Rande des zylinderförmigen Gebietes (Abb. 1b, dicke Kurve), was wiederum zu einer Erhöhung der Gleichgewichtskonzentration der Fremdatome im Festkörpermaterial am Rande des zylinderförmigen Gebietes führt (Abb. 1b, dünne Kurve).
Im Verlaufe des Temperprozesses bildet sich nunmehr ein Konzentrationsprofil der Fremdatome heraus (Abb. 1b, dünne Kurve), das zu einer Diffusion von Fremdatomen sowohl vom Rand des zylinderförmigen Gebietes nach außen in das Festkörpermaterial als auch vom Rand des zylinderförmigen Gebietes nach innen führt. Die Präzipitate am Rande des zylinderförmigen Gebietes lösen sich dadurch beschleunigt auf. Die in das zylinderförmige Gebiet diffundierenden Fremdatome erhöhen dort die Konzentration der gelösten Fremdatome über die Gleichgewichtskonzentration der dortigen Präzipitate, was zum Wachstum derselben führt (Abb.lc, dicke Kurve).
Die gewachsenen Präzipitate haben eine geringere Gleichgewichtskonzentration, so daß diese gewachsenen Präzipitate in der Zylinderschale nun durch Diffusion Fremdatome von außerhalb und innerhalb dieser Zylinderschale absaugen (Abb. 1c, dünne Kurve), bis die Präzipitate an beiden Seiten dieser Zylinderschale erst teilweise (Abb. 1d, dicke Kurve) und schließlich vollständig aufgelöst sind.
Je nach Durchmesser des zylinderförmigen Gebietes und der Ausgangskonzentration der Fremdatome in diesem Gebiet saugt die Zylinderschale größerer Präzipitate alle Präzipitate innerhalb dieser Zylinderschale ab, oder es bilden sich weitere Zylinderschalen großer Präzipitate. Die großen Präzipitate koaleszieren schließlich und bilden eine oder mehrere Zylinderschalen aus der chemischen Verbindung zwischen dem Festkörpermaterial und den Fremdatomen.

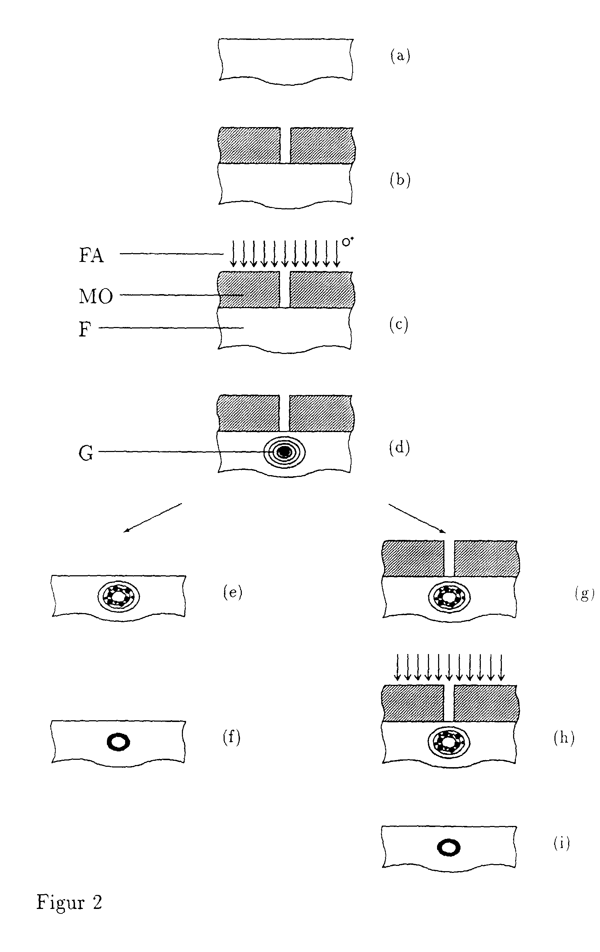

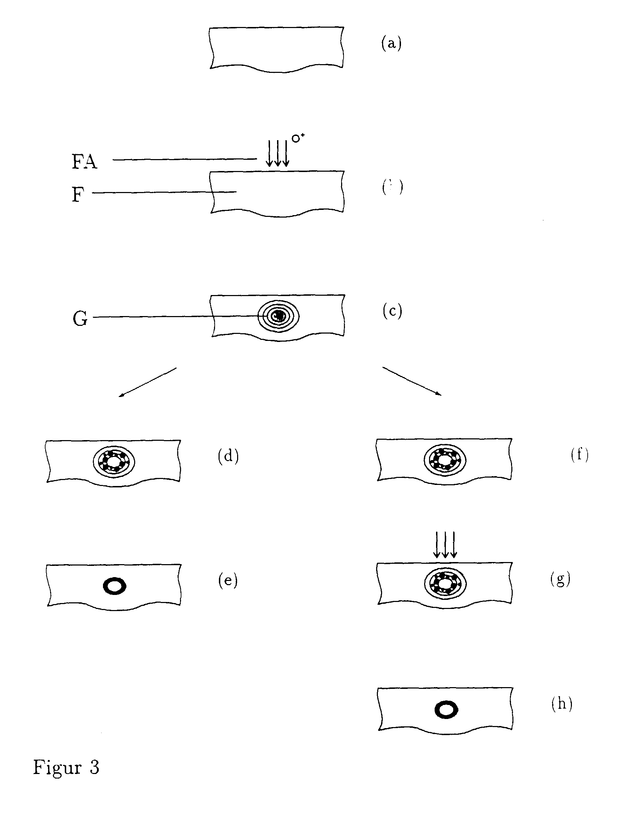

Das erfindungsgemäße Verfahren läßt sich zum Beispiel durchführen, indem die monokristalline Oberfläche eines Halbleiterkristalls, insbesondere eines Siliciumkristalls, mit Sauerstoffionen (Energie 200 keV, Dosis 2x10¹⁷ lonen/cm² beschossen wird. Es kann vorteilhaft sein, während der Ionenimplantation die Temperatur des Halbleiterkristalls oberhalb der Raumtemperatur zu halten, z.B. sind für Silicium Implantationstemperaturen zwischen 400...700 °C üblich. Um lokal streifenförmige Gebiete zu implantieren, bedeckt man vor der Implantation die Festkörperoberfläche mit einer Implantationsmaske, die streifenförmige Öffnungen von 0.2 µm Breite hat (siehe Abb. 2a-2d). Alternativ werden ohne Verwendung einer Maske streifenförmige Gebiete lokal mit einem lonenenmikrostrahl gleicher Ionenenergie und -dosis erzeugt, der Ionenstrahl wird auf einen Durchmesser von 0.2 ... 0.3 µm fokussiert (Abb. 3a-3c).

Nach der Ionenimplantation wird die implantierte Struktur bei hohen Temperaturen unterhalb der Schmelztemperaturen des Festkörpers und der chemischen Verbindung getempert. Für die oben beschriebene lokal Sauerstoff-ionenimplantierte Siliciumscheibe kann getempert werden bei Temperaturen von 1100°C über viele Stunden bis zu etwa 1400°C über viele Minuten. Generell gilt, daß für höhere Temperaturen kürzere Temperzeiten hinreichend sind. Ein günstiges Temperregime verwendet Temperzeiten von wenigen Stunden bei 1350°C. Durch die so definierten Implantations- und Temperbedingungen wird erreicht, daß sich beim Tempern eine Zylinderschale aus Präzipitaten der chemischen Verbindung aus den Festkörperatomen und den implantierten Atomen bildet (Abb. 2e bzw. 3d). Für das oben genannte Beispiel sind das Siliciumdioxidpräzipitate im Silicium. Weiteres Tempern führt für optimale Verfahrensparameter zur Koaleszenz der Präzipitate, wodurch man schließlich einen geschlossenen Hohlzylinder aus der chemischen Verbindung erhält (Abb. 2f bzw. 3e).

Im oben genannten Beispiel erhält man ein Rohr (Hohlzylinder) aus Siliciumdioxid, das im Silicium parallel zur Oberfläche liegt und dessen Inneres, die Seele, aus Silicium besteht. Die Koaleszenz der Präzipitate zu einer geschlossenen Rohrwand kann vorteilhaft unterstützt werden, indem man nur bis zur Ausbildung der Zylinderschale aus Präzipitaten tempert und durch eine zweite Ionenimplantation mit nachfolgender Temperung (gleiche Implantations- und Temperbedingungen wie im ersten Schritt) die Koaleszenz der Präzipitate stabilisiert (Abb. 2g-2i bzw. Abb. 3f-3h).

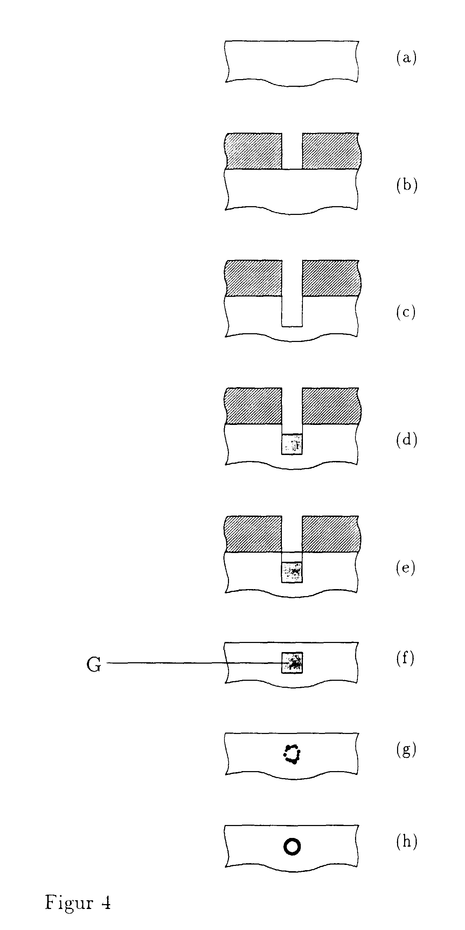

Im Beispiel der Abb. 4 wird gezeigt, wie das Gebiet mit Fremdatomen durch ein Schichtabscheideverfahren unter die Festkörperoberfläche eingebracht werden kann. Diese Methode wendet man z.B. vorteilhaft für das Einbringen von etwa 10 Atomprozenten Kobalt in ein Gebiet unter der Siliciumoberfläche an. Durch eine Maske von 0.3 µm Öffnung (Abb. 4b) wird mit einem Ätzverfahren ein Graben von 0.7 µm Tiefe ins Silicium geätzt (Abb. 4c), der mittels eines geeigneten Epitaxieverfahrens bis zu einer Tiefe von 0.4 µm mit Silicium gefüllt wird, das etwa 10 Atomprozente Kobalt enthält (Abb. 4d). Anschließend wird der Graben bis zur Siliciumoberfläche mit reinem Silicium gefüllt (Abb. 4e) und die Maske entfernt (Abb. 4f). Nachfolgend wird das Gebiet bei etwa 1000°C für etwa eine Stunde getempert, wobei über die Formierung einer Zylinderschale aus Kobaldsilicidpräzipitaten (Abb. 4g) eine vergrabene Röhre aus Kobaltsilicid entsteht (Abb. 4h).

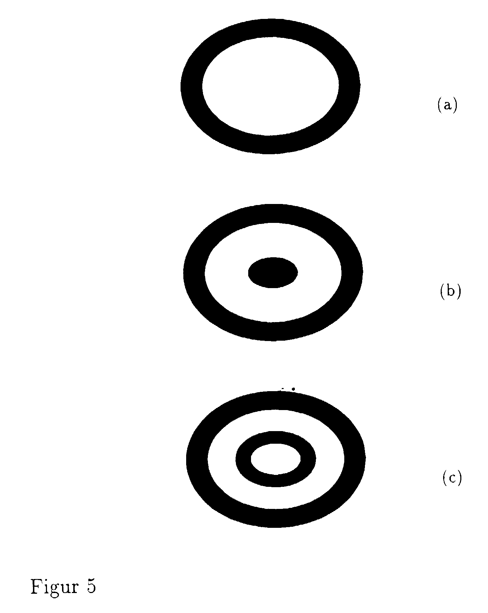

Erhöht man im Vergleich zu den oben beschriebenen Fällen die Konzentration der eingebrachten Fremdatome (z.B. durch Erhöhung der Implantationsdosis), so wird während des Temperschritts innerhalb des Rohres ein zusätzliches Rohr aus der chemischen Verbindung ohne Seele, d.h. ein Draht, erzeugt (Abb. 5b). Bei weiterer Erhöhung der Konzentration der eingebrachten Fremdatome kann während des Temperschrittes ein Rohr im Rohr erzeugt werden (Abb. 5c). Die Komplexität der röhrenförmigen Mikrostruktur kann nicht nur über die Konzentration der eingebrachten Fremdatome, sondern auch über die Breite und Höhe des Ausgangsgebietes mit Fremdatomen beeinflußt werden.

Durch Einsatz eines selektiven naßchemischen Ätzvefahrens, z.B. KOH/H2O-Gemisch mit einer Ätzratenselektivität von Si/SiO2 = 500, kann über eine lithografisch strukturierte Ätzmaske die röhrenförmige Struktur mit einer SiO2-Oberfläche lokal durch Entfernen des Siliciumsubstrates bis in eine Tiefe von einigen Mikrometern freigelegt werden. In einem weiteren plasma-chemischen Ätzprozeß mit einer Ätzratenselektivität von SiO2/Si = 15 kann zusätzlich noch die SiO2-Ummantelung der freigelegten Struktur entfernt werden. Mit derartigen freitragenden röhrenförmigen Strukturen lassen sich neuartige dreidimensionale elektronische, sensorische und mikromechanische Halbleitervorrichtungen herstellen.

## Patentansprüche

1. Verfahren zur Herstellung röhrenförmiger Mikrostrukturen in Festkörpern, dadurch gekennzeichnet, daß in ein in Höhe und Breite auf Submikrometerabmessungen begrenztes Gebiet (G) eines Festkörpers (F) Fremdatome (FA) eingebracht werden, die mit den Festkörperatomen eine chemische Verbindung einzugehen geeignet sind, wobei die Konzentration der Fremdatome im Gebiet (G) nach dem Einbringen maximal 50% der der Stöchiometrie entsprechenden Konzentration der Fremdatome in der chemischen Verbindung beträgt, und daß anschließend eine Temperbehandlung bei hohen Temperaturen unterhalb der Schmelztemperaturen des Festkörpermaterials und der chemischen Verbindung derart erfolgt, daß sich Festkörpermaterial und chemische Verbindung durch Bildung von Präzipitaten der chemischen Verbindung entmischen, daß die Präzipitate über das an sich bekannte Ostwaldreifen weiter wachsen und sich in einer oder mehreren Zylinderschalen konzentrieren, bis über die Koaleszenz der Präzipitate scharfe Phasengrenzen zwischen der in den Zylinderschalen konzentrierten chemischen Verbindung und dem Festkörpermaterial innerhalb und außerhalb dieser Schalen entstanden sind.

2. Verfahren nach Anspruch 1, dadurch gekennzeichnet, daß die Fremdatome in Form beschleunigter Ionen durch Maskenfenster einer maskierten Festkörperoberfläche (MO) unter die Festkörperoberfläche in das Gebiet (G) eingebracht werden.

3. Verfahren nach Anspruch 1, dadurch gekennzeichnet, daß die Fremdatome (FA) in Form beschleunigter Ionen mit einem schreibenden lonenmikrostrahl mit weniger als einem Mikrometer Durchmesser des Strahlfokus unter die Festkörperoberfläche in das Gebiet (G) eingebracht werden.

4. Verfahren nach Anspruch 1, dadurch gekennzeichnet, daß durch ein Schichtabscheideverfahren, vorzugsweise durch selektive Molekularstrahlepitaxie, das Gebiet (G) bestehend aus einer Mischung aus Festkörpermaterial und Fremdatomen lokal abgeschieden wird, und daß anschließend eine Bedeckung des Gebietes (G) durch Abscheiden von reinem Festkörpermaterial erfolgt.

5. Verfahren nach Anspruch 1 und 4, dadurch gekennzeichnet, daß die Fremdatome in Form ihrer chemischen Verbindung mit dem Festkörpermaterial im Gebiet (G) abgeschieden werden.

6. Verfahren nach Anspruch 1,2 und 3, dadurch gekennzeichnet, daß durch die Dosis und Energie der implantierten Ionen und die Parameter des Temperverfahrens die Anzahl der ineinander geschachtelten Röhren bestimmt wird.

7. Verfahren nach Anspruch 1 und 4, dadurch gekennzeichnet, daß durch die Parameter des Abscheide- und Temperverfahrens des Gebietes (G) die Anzahl der ineinander geschachtelten Röhren bestimmt wird.

8. Verfahren nach Anspruch 1, 6 und 7, dadurch gekennzeichnet, daß die innerste Röhre ohne Seele als Draht hergestellt wird.

9. Verfahren nach Anspruch 1 , dadurch gekennzeichnet, daß im Festkörper gleichzeitig mehrere Gebiete (G) erzeugt und in röhrenförmige Mikrostrukturen umgewandelt werden.

10. Verfahren nach Anspruch 1, dadurch gekennzeichnet, daß Fremdatome in den Festkörper eingebracht werden, die mit dem Festkörpermaterial eine dielektrische, isolierende chemische Verbindung bilden, die das innere Gebiete der Röhre vom äußeren Gebiet elektrisch isoliert.

11. Verfahren nach Anspruch 1, dadurch gekennzeichnet, daß Fremdatome in den Festkörper eingebracht werden, die mit dem Festkörpermaterial eine elektrisch gut leitende chemische Verbindung bilden.

12. Verfahren nach Anspruch 1, dadurch gekennzeichnet, daß Fremdatome in den Festkörper eingebracht werden, die mit dem Festkörpermaterial eine chemische Verbindung bilden, deren optischer Brechungsindex sich vom Festkörpermaterial unterscheidet und für definierte optische Wellenlängen eine geringe optische Absorption aufweist.

13. Verfahren nach Anspruch 1, dadurch gekennzeichnet, daß das Festkörpermaterial aus Silicium besteht und als Fremdatome Sauerstoffionen mit einer Energie von 200keV in einer Dosis von wenigen 10¹⁷ pro Quadratzentimeter in das Gebiet (G) implantiert werden, und daß durch eine Temperaturbehandlung im Bereich von mindestens 1100 C über einigen Stunden bis maximal 1405 C über einige Minuten eine vergrabene, Silicium-gefüllte Siliciumdioxidröhre hergestellt wird.

14. Verfahren nach Anspruch 1, dadurch gekennzeichnet, daß die Herstellung der röhrenförmigen Mikrostruktur durch eine Sequenz von Einbring- und Temperprozessen erfolgt.

15. Verfahren nach Anspruch 1-14, dadurch gekennzeichnet, daß mittels naß- oder trockenchemischer anisotroper und/oder selektiver Ätztechniken die vergrabenenen Röhrenstrukturen lokal und geometrisch definiert freigelegt werden und als freitragende dreidimensionale festkörperelektronische, vakuumelektronische, mikromechanische, mikrooptische oder mikrofluidische sowie mikrosensorische passive oder aktive Bauelemente hergestellt, und als integrierte Mikrosysteme ausgelegt werden können.

## Claims

1. Method for manufacture of tubular microstructures in solids, in which foreign atoms (FA) are introduced to an area (G) in a solid (F), the height and width of which is limited to submicrometer dimensions, the foreign atoms being suitable to form a chemical compound with the atoms of the solid, whereby the concentration of foreign atoms in the area (G) after introduction is max. 50 % of the stoichiometric concentration of the foreign atoms in the chemical compound, and that temperature treatment is then carried out at high temperatures below the melting temperature of the solid material and of the chemical compound, in such a way that the solid material and the chemical compound segregate by formation of precipitates of the chemical compound, that the precipitates grow further by the known Ostwald maturing and concentrate in one or more cylindrical shells, until coalescence of the precipitates creates sharp phase boundaries between the chemical compound concentrated in the cylindrical shells and the solid material inside and outside these shells.

2. Method according to claim 1, in which the foreign atoms are introduced under the surface of the solid in the area (G) through mask windows of a masked surface of a solid (MO), in the form of accelerated ions.

3. Method according to claim 1, in which the foreign atoms (FA) are introduced under the surface of the solid in the area (G) in the form of accelerated ions using a writing ion microray with a ray focus diameter of less than one micrometer.

4. Method according to claim 1, in which the area (G) comprising a mixture of solid material and foreign atoms is deposited locally, by a layer depositing method, preferably by selective molecular beam epitaxy, and that the area (G) is then covered by depositing pure solid material.

5. Method according to claims 1 and 4, in which the foreign atoms are deposited in the area (G) in the form of their chemical compound with the solid material.

6. Method according to claims 1, 2 and 3, in which the number of interpenetrating tubes is determined by the dose and energy of the implanted ions and the parameters of the tempering process.

7. Method according to claims 1 and 4, in which the number of interpenetrating tubes is determined by the parameters of the depositing and tempering process in the area (G).

8. Method according to claims 1, 6 and 7, in which the innermost tube is manufactured as a wire, without a core.

9. Method according to claim 1, in which simultaneously, in the solid, a number of areas (G) are created and converted into tubular microstructures.

10. Method according to claim 1, in which foreign atoms are introduced in the solid, which form a dielectric, insulating chemical compound with the solid material, which electrically insulates the area inside the tube from the area outside.

11. Method according to claim 1, in which foreign atoms are introduced in the solid, which form a chemical compound of good electrical conductivity with the solid material.

12. Method according to claim 1, in which foreign atoms are introduced in the solid, which form a chemical compound with the solid material, which has a different index of refraction from that of the solid material, and has low optical absorption for defined optical wavelengths.

13. Method according to claim 1, in which the solid material consists of silicium, and as foreign atoms oxygen ions with energy of 200 keV in a dose of few 10¹⁷ ions/cm² are implanted in the area (G), and that a buried silicium-filled silicium dioxide tube is manufactured by temperature treatment in the range of at least 1100 °C for several hours to maximum 1405 °C for several minutes.

14. Method according to claim 1, in which the manufacture of the tubular microstructure is realized by a sequence of introduction and tempering processes.

15. Method according to claims 1 - 14, in which the buried tube structures are exposed, locally and in a geometrically defined manner, by wet or dry chemical anisotropic and/or selective etching techniques, and can be manufactured as unsupported three-dimensional solid-state electronic, vacuum electronic, micro-mechanical, micro-optic, micro-fluid and micro-sensoric passive or active components, and designed as integrated microsystems.

## Revendications

1. Procédé de fabrication de microstructures tubulaires dans des solides, caractérisé par le fait que des atomes étrangers (AE) sont introduits dans une zone (Z) d'un solide (S) limitée en hauteur et en largeur à des dimensions sous-micrométriques, ces atomes étrangers étant aptes à former une combinaison chimique avec les atomes du solide, la concentration des atomes étrangers dans la zone (Z) après l'introduction étant au maximum égale à 50 % de la concentration des atomes étrangers correspondant à la stoechiométrie dans la combinaison chimique; procédé caractérisé aussi par le fait qu'ensuite, un traitement thermique à hautes températures, inférieures à la température de fusion de la matière du solide et de la combinaison chimique, se produit de telle sorte que la matière du solide et la combinaison chimique entrent en séparation grâce à la formation de précipités de la combinaison chimique, que les précipités continuent de croître sur l'anneau d'Ostwald connu en soi et se concentrent en une ou plusieurs enveloppes cylindriques, jusqu'à ce que, grâce à la coalescence des précipités, des limites de phases nettes se soient formées à l'intérieur et à l'extérieur de ces enveloppes, entre la combinaison chimique concentrée dans les enveloppes cylindriques et la matière du solide.

2. Procédé selon spécification 1, caractérisé par le fait que les atomes étrangers sont introduits dans la zone (Z) sous la surface du solide sous forme d'ions accélérés, à travers des fenêtres de masquage d'une surface masquée du solide (SM).

3. Procédé selon spécification 1, caractérisé par le fait que les atomes étrangers (AE) sont introduits dans la zone (Z) sous la surface du solide sous forme d'ions accélérés, avec un microfaisceau ionique enregistreur dont le foyer a un diamètre inférieur à un micron.

4. Procédé selon spécification 1, caractérisé par le fait que, grâce à un procédé de séparation des couches, de préférence par épitaxie sélective par faisceau moléculaire, la zone (Z) composée d'un mélange de matière du solide et d'atomes étrangers est séparée localement, et par le fait qu'ensuite, une couverture de la zone (Z) se produit grâce à la séparation de matière pure du solide.

5. Procédé selon spécifications 1 et 4, caractérisé par le fait que les atomes étrangers sont séparés dans la zone (Z) sous la forme de leur combinaison chimique avec la matière du solide.

6. Procédé selon spécifications 1, 2 et 3, caractérisé par le fait que le nombre de tubes encastrés les uns dans les autres est déterminé par la dose et l'énergie des ions implantés et par les paramètres du procédé de trempage.

7. Procédé selon spécifications 1 et 4, caractérisé par le fait que le nombre de tubes encastrés les uns dans les autres est déterminé par les paramètres du procédé de séparation et de trempage de la zone (Z).

8. Procédé selon spécifications 1, 6 et 7, caractérisé par le fait que le tube le plus interne est fabriqué sans âme, sous forme de fil métallique.

9. Procédé selon spécification 1, caractérisé par le fait que plusieurs zones (Z) sont produites en même temps dans le solide et transformées en microstructures tubulaires.

10. Procédé selon spécification 1, caractérisé par le fait que des atomes étrangers sont introduits dans le solide, ces atomes formant avec la matière du solide une combinaison chimique diélectrique isolante, qui isole électriquement la zone interne des tubes par rapport à la zone externe.

11. Procédé selon spécification 1, caractérisé par le fait que des atomes étrangers sont introduits dans le solide, ces atomes formant avec la matière du solide une combinaison chimique très électroconductrice.

12. Procédé selon spécification 1, caractérisé par le fait que des atomes étrangers sont introduits dans le solide, ces atomes formant avec la matière du solide une combinaison chimique dont l'indice de réfraction optique se différencie de la matière du solide et présente une faible absorption optique pour des longueurs d'ondes optiques définies.

13. Procédé selon spécification 1, caractérisé par le fait que la matière du solide est composée de silicium et que, en tant qu'atomes étrangers, une quantité d'ions oxygène inférieure à 10¹⁷ ions/cm² est implantée dans la zone (Z) avec une énergie de 200 keV, et par le fait qu'un tube de dioxyde de silicium enfoui et rempli de silicium est fabriqué grâce à un traitement thermique, dans la plage d'au moins 1100 °C pendant quelques heures à 1405 °C maximum pendant quelques minutes.

14. Procédé selon spécification 1, caractérisé par le fait que la fabrication de la microstructure tubulaire se produit par une série de procédés d'introduction et de trempage.

15. Procédé selon spécifications 1 -14, caractérisé par le fait que, au moyen de techniques de corrosion chimiques humides ou sèches anisotropes et/ou sélectives, les structures tubulaires enfouies sont libérées en étant définies localement et géométriquement et peuvent être fabriquées en tant qu'éléments à trois dimensions non soutenus, électroniques monolithiques, électroniques à vide, micromécaniques, microoptiques ou microfluides ainsi qu'en tant qu'éléments microsensoriels passifs ou actifs, et peuvent être conçues comme microsystèmes intégrés.
